# EUROPÄISCHE PATENTSCHRIFT

(11) **EP 0 397 967 B1**
(45) Veröffentlichungstag und Bekanntmachung des Hinweises auf die Patenterteilung: **19.07.1995**
(21) Anmeldenummer: 90102818.3
(22) Anmeldetag: 13.02.1990
(51) Int. Cl.: H01Q 17/00, H01Q 15/00, H05K 9/00

(54) **Radarstrahlen absorbierende Aussenfassade**
Radar-absorbing outer façade
Façade extérieure absorbant des faisceaux radars

(30) Priorität: 19.05.1989 DE 3916416
(43) Veröffentlichungstag der Anmeldung: 22.11.1990
(73) Patentinhaber: G + H MONTAGE GMBH, D-67059 Ludwigshafen (DE)
(72) Erfinder: Druffner, Adolf, D-6737 Böhl-Iggelheim 1 (DE); Körner, Christian, D-6940 Weinheim-Rippenweiher (DE)
(74) Vertreter: Grünecker, Kinkeldey, Stockmair & Schwanhäusser Anwaltssozietät

(56) Entgegenhaltungen:
- DE-B- 1 165 697
- DE-B- 1 206 040
- NTZ NACHRICHTECHNISCHE ZEITSCHRIFT. vol. 41, no. 5, Mai 1988, BERLIN DE Seiten280 - 283; Dominik et al.: "Hochfrequenz-absorbierende Materialien"

## Beschreibung

Die Erfindung betrifft eine Außenfassade gemäß dem Oberbegriff des Anspruchs 1, die zur Reflexionsminderung von Radarstrahlen geeignet ist.

Im Bereich von Flughäfen wird die für die Flugsicherung notwendige Radarortung von Flugzeugen häufig durch Reflexion der Radarwellen an den umliegenden Gebäuden gestört. Dabei liegen die Frequenzen der Radarwellen vorrangig im L-Band zwischen 1,03 und 1,09 GHz, was einer Wellenlänge von etwa 27 bis 30 cm entspricht. Daneben können in bezug auf die Reflexion aber auch Radarwellen aus dem S-Band eine Rolle spielen.

Aus dem Artikel von Hans Dominik und Eberhard Eckert "Hochfrequenz-absorbierende Materialien" in Nachrichtentechnische Zeitschrift, Band 41, Nr. 5, Mai 1988, Seiten 280-283, ist ein Grundtyp für eine Abschirmung elektrischer und elektronischer Systeme gegen hochfrequente Strahlung bekannt, der auf dem Resonanzprinzip beruht, wobei hinter einer Widerstandsfolie ein reflektierender Metallschirm im Abstand von λ/4 einer zu unterdrückenden, im wesentlichen darauf senkrecht einfallenden Welle angeordnet ist. Ein derartiger Resonanzabsorber zeigt eine gute Reflexionsunterdrückung nur in einem verhältnismäßig schmalen Wellenlängenbereich um die Resonanzfrequenz bzw. in einem schmalen Einfallswinkelbereich der zu absorbierenden Strahlung, für den der Resonanzhohlraum entsprechend ausgelegt ist.

Es ist die Aufgabe der vorliegenden Erfindung, eine verbesserte Außenfassade zu schaffen, die die Reflexion von auf ein Gebäude auftreffenden elektromagnetischen Wellen wesentlich herabsetzt.

Die erfindungsgemäße Lösung dieser Aufgabe ist dadurch gekennzeichnet, daß eine Außenschale aus einem Material mit einer geringen Permeabilität und/oder einer niedrigen Dielektrizitätszahl und eine Innenschale vorgesehen sind, zwischen denen die Schicht aus einem elektromagnetisch wirksamen Widerstandsmaterial angeordnet ist, und daß zwischen der Schicht aus einem elektromagnetisch wirksamen Widerstandsmaterial und der elektrisch leitenden Schicht eine Radarstrahlen absorbierende Lage vorgesehen ist, die einen Schichtaufbau derart aufweist, daß eine ein Dämmaterial und eine ein elektromagnetisch wirksames Widerstandsmaterial aufweisende Schicht abwechselnd aufeinanderfolgend derart angeordnet sind, daß die Stoßflächen der unterschiedlichen Schicht aus Dämmaterial und Widerstandsmaterial im wesentlichen senkrecht zur Außenschale angeordnet sind.

Durch die erfindungsgemäße Lösung wird vorgeschlagen, eine Außenfassade vorzusehen, die eine wesentliche Dämpfung der Reflexion durch Kombination einer resonanzartigen Dämpfung in einem verhältnismäßig schmalen Frequenzbereich mit einer breitbandigen Reflexionsdämpfung erreicht. Dadurch, daß für die Außenschale ein Material mit einer geringen Permeabilität und einer niedrigen Dielektrizitätszahl gewählt wird, wird verhindert, daß es an der Außenschale zu Reflexionen kommt, bevor die elektromagnetischen Wellen den absorptionswirksamen Teil der Außenfassade erreicht haben.

Vorzugsweise besteht die Außenschale deshalb aus Glas, Acrylglas, zementgebundenem Holzspanplattenmaterial, Keramik, mineralischem zementgebundenem Plattenmaterial, Kunststoff oder einem ähnlichen Material.

Die für die Absorption in einem schmalen Frequenzbereich vorgeschlagene erfindungsgemäße Lösung kann vorteilhaft ausgestaltet werden, indem die Widerstandsschicht des Resonanzabsorbers direkt auf die der Innenschale zugewandte Seite der Außenschale aufgebracht wird, so daß die Widerstandsschicht nicht als gesondertes Bauelement vorgesehen zu werden braucht. Darüber hinaus kann die elektrisch leitende zweite Schicht zur Innenschale beabstandet sein, wobei in dem Zwischenraum zwischen dieser eine Reflexionsfläche bildenden zweiten Schicht und der Innenschale vorteilhaft eine Dämmschicht für die Wärme- und Schalldämmung untergebracht werden kann.

Mit der breitbandigen Reflexionsdämpfung wird zusätzlich eine Wärme- und Schalldämmung durch die ein Dämmaterial aufweisenden Schichten der aus verschiedenen Schichten aufgebauten Lage erreicht. Vorteilhafterweise übernimmt damit die die elektromagnetischen Wellen absorbierende Lage zusätzlich auch noch die Funktion einer Wärme- und Schalldämmung.

Weitere vorteilhafte Ausgestaltungsmöglichkeiten der Erfindung gehen aus den Unteransprüchen hervor.

Die Erfindung soll nun anhand von Ausführungsbeispielen und der beiliegenden Zeichnungen näher erläutert und beschrieben werden. Es zeigen:
Fig. 1 einen ersten Teil der für eine erfindungsgemäße Fassadenkonstruktion vorgesehenen Kombination, der für die Reflexionsdämpfung in einem begrenzten Frequenzbereich vorgesehen ist, und
Fig. 2 einen zweiten Teil der für die Außenfassade vorgesehenen Kombination, der zur breitbandigen Reflexionsdämpfung vorgesehen ist.

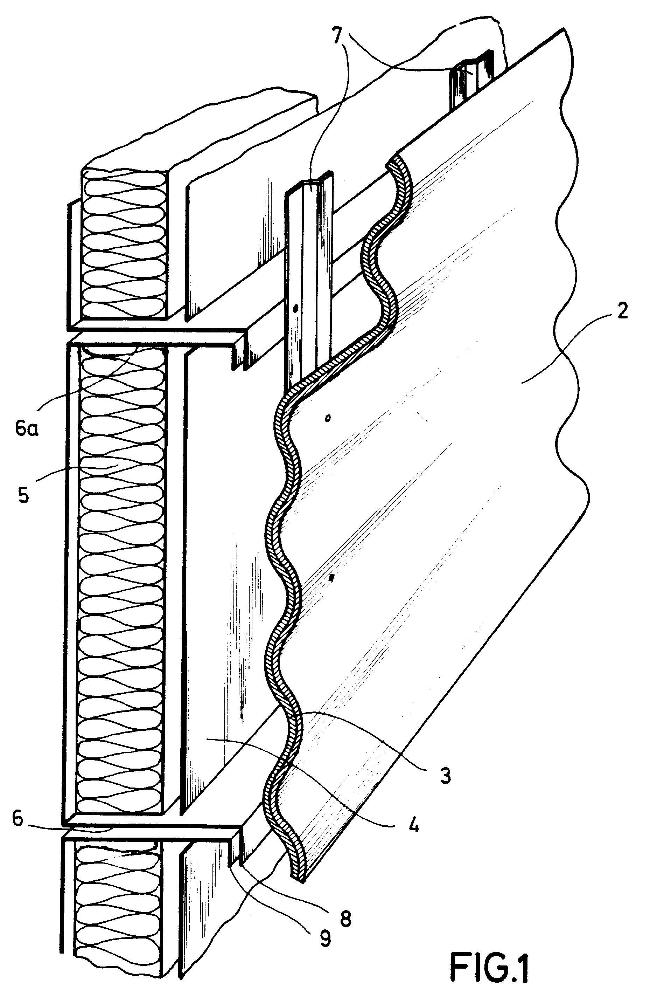

In Fig. 1 ist mit dem Bezugszeichen 1 eine dem Gebäude zugewandte Innenschale der Außenfassade bezeichnet. Die Innenschale besteht im vorliegenden Beispiel aus Blechsegmenten, die jeweils unter Bildung von Horizontalträgern 6 bzw. 6a am oberen und unteren Rand abgewinkelt sind. Diese profilförmigen Segmente, die direkt mit der Unterkonstruktion verbunden sein können, sind zur Bildung einer Innenschale nebeneinander bzw., unter Bildung von Stößen zwischen den Horizontalträgern, übereinander angeordnet. Mit 8 und 9 sind nach unten gerichtete Abwinkelungen der Horizontalträger an dem der Außenschale zugewandten Ende bezeichnet. Mit 5 ist eine Dämmschicht bezeichnet, die vorzugsweise aus unbrennbarer Mineralwolle besteht und an ihrem unteren Rand durch den Horizontalträger 6 abgestützt ist. In Richtung auf die Innenschale ist vor der Dämmschicht eine elektrisch leitende Schicht 4 angeordnet, die im vorliegenden Beispiel aus Blech besteht und wie die Dämmschicht 5 durch den Horizontalträger 6 am unteren Rand abgestützt ist. Zweckmäßig ist die Blechwand 4 zur Gewährleistung der Formstabilität an ihrem oberen Rand mit dem Horizontalträger 6a verbunden. Außerdem kann zweckmäßig eine Verbindung zwischen dem unteren Rand der Blechwand und dem Horizontalträger 6a hergestellt sein, so daß ein formstabiler Einschluß der Dämmschicht 5 zwischen der Wandung 4 und der Innenschale 1 gewährleistet ist. Mit dem Bezugszeichen 7 sind als Unterkonstruktion für eine Außenschale 2 dienende Vertikalträger bezeichnet, die jeweils über die Abwinklung 8 mit dem unteren Horizontalträger 6 verbunden sind. Zweckmäßig erfolgt die Verbindung derart, z.B. durch Verschrauben, daß jeweils auch eine Verbindung zwischen den Abwinklungen zweier übereinander liegender Horizontalträger hergestellt ist. An den Vertikalträgern 7 ist die Außenschale 2 befestigt, die im vorliegenden Beispiel ein Wellprofil aufweist. Auf der der Innenschale zugewandten Seite des Wellprofils ist eine Widerstandsschicht 3 aufgetragen, z.B. durch Spachteln, Streichen oder Spritzen, die ein Widerstandsmaterial, wie z.B. Ruß oder Graphit, enthält.

Beim Einfall elektromagnetischer Radarwellen kommt es durch die Widerstandsschicht 3 und die zu der Widerstandsschicht 3 im Abstand angeordnete Reflexionsschicht 4 aus einem leitenden Material zu einer resonanzartigen Absorption von solchen elektromagnetischen Wellen, deren Wellenlänge den vierfachen Wert des (mittleren) Abstandes zwischen der Widerstandsschicht 3 und der Reflexionsebene 4 aufweist. Es erfolgt also eine Absorption vorwiegend in einem schmalen Frequenzbereich. Indem die Außenschale 2 aus einem Material mit geringer Permeabilität und niedriger Dielektrizitätszahl besteht, wird verhindert, daß auf die Fassade auftreffende Wellen an der Außenschale reflektiert werden, bevor sie die absorptionswirksame Widerstandsschicht bzw. die Reflexionsschicht 4 erreichen. Als für die Außenschale geeignete Materialien können Glas, Acrylglas, zementgebundene Holzspanplatten, Keramik, mineralische zementgebundene Platten, Kunststoff und ähnliches verwendet werden. Vorzugsweise sind für die Außenschale Materialien vorzusehen, deren relative Permeabilität bzw. deren Dielektrizitätszahl Werte zwischen 1 und 1,5 aufweist.

Durch die Dämmschicht zwischen der Reflexionsschicht 4 und der Innenschale 1 wird zusätzlich zur Absorption der elektromagnetischen Strahlung eine Absorption von Schallwellen sowie eine Wärmedämmung erreicht.

Anstelle einer mit der Außenschale verbundenen Widerstandsschicht könnten im (mittleren) Abstand λ/4 von der Reflexionsschicht 4 auch mehrere Einzelschichten vorgesehen sein, die eine unterschiedliche Permeabilität bzw. Dielektrizitätszahl derart aufweisen oder unterschiedlich derart beabstandet sind, daß der Eingangswellenwiderstand dem Feldwellenwiderstand angepaßt ist.

Die im vorliegenden Beispiel hinter dem Resonanzabsorber, d.h. hinter der Reflexionsschicht 4, angeordnete Dämmschicht könnte auch in dem Zwischenraum zwischen der Widerstandsschicht 3 und der Reflexionsschicht 4 angeordnet sind, was zu einer Verbreiterung des absorbierten Wellenlängenbereiches führen würde.

Die Reflexionsschicht 4 könnte auch durch die Unterkonstruktion für die Außenschale oder durch die Innenschale gebildet sein und braucht nicht, wie im vorliegenden Ausführungsbeispiel, aus einer durchgehenden Wandung bestehen.

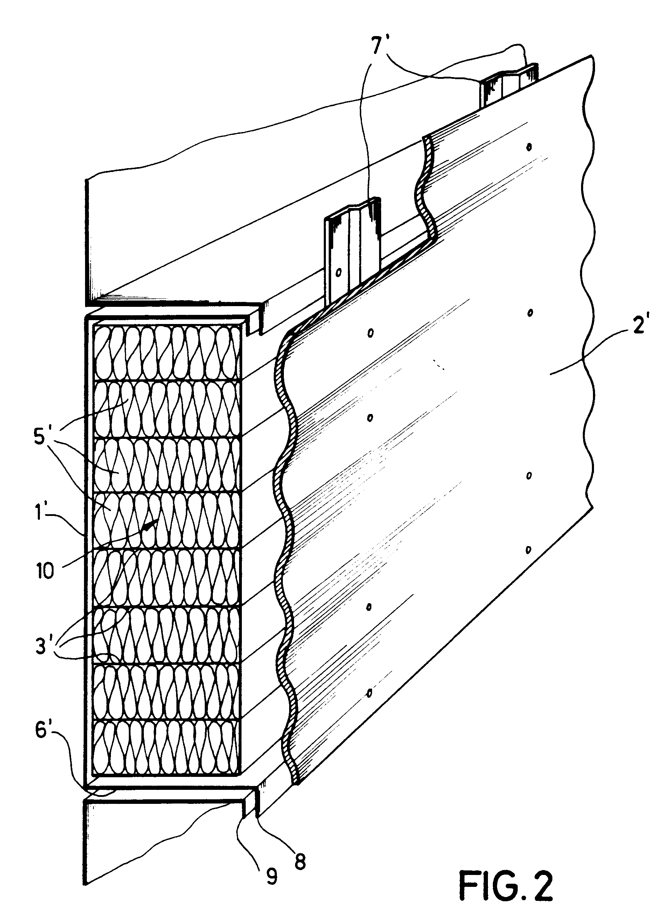

Das Beispiel in Fig. 2, in der gleiche oder ähnlich wirkende Teile die gleiche, nur mit einem Strich versehene Bezugszahl wie in Fig. 1 aufweisen, unterscheidet sich von dem in Fig. 1 dargestellten Beispiel dadurch, daß zwischen der Innenschale 1′ und der Außenschale 2′ eine den Zwischenraum zwischen beiden Schalen im wesentlichen ausfüllende Zwischenlage vorgesehen ist, die einen Schichtaufbau aufweist. Mit 3′ sind Widerstandsschichten bezeichnet, die jeweils zwischen Trägerschichten 5′ aus einem Dämmaterial angeordnet sind. Die Widerstandsschichten 3′ können wie die Widerstandsschicht 3 des Ausführungsbeispiels von Fig. 1 Widerstandsmaterialien wie Graphit oder Ruß enthalten und mit einem Basismaterial mit z.B. Glasvlies, Papier oder Folie in Verbindung gebracht sein. Möglicherweise kann auch eine Dispersion von Widerstandsmaterial direkt auf die Trägerschichten 5′ aufgebracht sein. Die Trägerschichten 5 bestehen vorzugsweise aus einem nichtbrennbaren Dämmaterial, zweckmäßig wird Mineralwolle verwendet. Im wie in der Fig. 2 gezeigt, sind die Stoßflächen zwischen den Schichten 3′ und 5′ senkrecht zur Innenschale bzw. Außenschale angeordnet. Die Stoßflächen zwischen den Schichten könnten aber auch, z.B., parallel zu den Schalen angeordnet sein. Es ist nicht erforderlich, daß die Widerstandsschichten 3′ zwischen den Trägerschichten als zusammenhängede oder/und durchgehende Schichten ausgebildet sind. Wie bei dem Beispiel gemäß der Fig. 1, besteht die Außenschale aus einem Material mit einer geringen Permeabilität und/oder einer niedrigen Dielektrizitätszahl mit vorzugsweisen Werten zwischen 1,0 und 1,5. Die Innenschale besteht zweckmäßig aus einem elektrisch leitfähigen Material, wie etwa Metall, vorzugsweise aus einem Blech.

Auf die Außenfassade auftreffende elektromagnetische Wellen passieren die Außenschale weitgehend reflexionsfrei und werden innerhalb der Zwischenlage unter Erzeugung von Strömen in den Widerstandsschichten weitgehend absorbiert, wodurch die Reflexion der Fassade gering ist. In bezug auf die Absorptionswirkung ist es von besonderem Vorteil, wenn das Widerstandsmaterial innerhalb der Zwischenlage durch entsprechende Gestaltung und Anordnung der Widerstandsschichten und/oder Verteilung des Widerstandsmaterials in den Widerstandsschichten, so verteilt ist, daß die auf ein Tiefenintervall bezogene Flächenmasse des Widerstandsmaterials in Richtung auf die Innenschale hin zunimmt.

Die einen Breitbandabsorber bildende, allgemein mit 10 bezeichnete Zwischenlage, könnte entgegen dem Beispiel von Fig. 2 auch zu der elektrisch leitenden Innenschale 1′ beabstandet sein, wodurch zusätzlich eine resonanzartige Absorption in schmalen Frequenzbereichen erzielbar ist. Je nach Wahl des Abstandes läßt sich eine Verschiebung der unteren Grenzfrequenz der absorbierenden Außenfassade erreichen. Die Verwendung einer leitfähigen Innenschale, die total reflektiert, ist in jedem Fall, auch wenn wie im vorliegenden Beispiel die Zwischenlage zur Innenschale nicht beabstandet ist, zweckmäßig, da in diesem Fall definierte Reflexionsverhältnisse an der Innenschale vorliegen.

Bei dem in Fig. 2 dargestellten Beispiel bewirkt die zur Absorption der elektromagnetischen Wellen vorgesehene Zwischenlage vorteilhaft gleichzeitig eine Wärme- und Schalldämmung, so daß hierfür keine zusätzlichen, die Tiefe der Fassade vergrößernde Dämmschichten vorgesehen zu werden brauchen. Wie bei dem Beispiel gemäß der Fig. 1 besteht die Innenschale vorteilhaft aus Segmenten, die als Profile ausgebildet und mit den Horizontalträgern verbunden sind. Dadurch wird eine einfache Konstruktion mit einer geringen Zahl verschiedener Bauteile erreicht.

Bei den in bezug zu den Fig. 1 und 2 beschriebenen Beispielen für eine Außenfassade liegt der Pegel der reflektierten Welle mindestens 20 Dezibel unter dem der einfallenden Welle. Das entspricht einer Reflexionsdämpfung von 20 Dezibel und einem Reflexionsfaktor von 0,1. Zweckmäßig weist der Ohmsche Widerstand der Widerstandsschichten Werte um 125 Ω/cm² auf.

Erfindungsgemäß sind die in den Fig. 1 und 2 dargestellten Beispiele miteinander kombiniert, indem eine als Breitbandabsorber wirkende Zwischenlage im Zwischenraum zwischen der Reflexionsschicht und der Widerstandsschicht des Resonanzabsorbers angeordnet ist.

## Patentansprüche

1. Radarstrahlen absorbierende Außenfassade mit einer Außenschale (2) aus einem Material mit einer geringen Permeabilität und/oder einer niedrigen Dielektrizitätszahl und mit einer Innenschale (1), zwischen denen eine Schicht aus einem elektromagnetisch wirksamen Widerstandsmaterial (3) angeordnet ist, bezüglich der im Abstand von λ/4 einer bevorzugt zu absorbierenden Wellenlänge λ eine elektrisch leitende Schicht (4) zur Bildung eines Resonanzabsorbers angeordnet ist **dadurch gekennzeichnet**, daß zwischen der Schicht (3) aus dem elektromagnetisch wirksamen Widerstandsmaterial und der elektrisch leitenden Schicht (4) eine Radarstrahlen absorbierende Lage vorgesehen ist, die einen Schichtaufbau derart aufweist, daß eine ein Dämmaterial (5′) und eine ein elektromagnetisch wirksames Widerstandsmaterial aufweisende Schicht (3′) abwechselnd aufeinanderfolgend derart angeordnet sind, daß die Stoßflächen der unterschiedlichen Schicht (3′, 5′) aus Dämmaterial und Widerstandsmaterial im wesentlichen senkrecht zur Außenschale angeordnet sind.

2. Außenfassade nach Anspruch 1, **dadurch gekennzeichnet**, daß die Außenschale (2, 2′) aus Glas, Acrylglas, zementgebundenem Holzspanplattenmaterial, Keramik, mineralischem zementgebundenem Plattenmaterial oder Kunststoff besteht.

3. Außenfassade nach einem der Ansprüche 1 oder 2, **dadurch gekennzeichnet**, daß die Innenschale (1, 1′) eine Lage aus einem elektrisch leitfähigem Material aufweist.

4. Außenfassade nach Anspruch 3, **dadurch gekennzeichnet**, daß die elektrisch leitfähige Lage der Innenschale (1, 1′) die Bewehrung einer Stahlbetonwand umfaßt.

5. Außenfassade nach einem der Ansprüche 1 bis 4, **dadurch** **gekennzeichnet**, daß die ein Widerstandsmaterial aufweisende Schicht (3 des Resonanzabsorbers bzw. die ein Widerstandsmaterial aufweisenden Schichten (3′) der Radarstrahlen absorbierenden Lage aus einem Basismaterial, das mit einer Dispersion aus einem Widerstandsmaterial in Verbindung gebracht ist, bestehen.

6. Außenfassade nach Anspruch 5, **dadurch gekennzeichnet**, daß das Basismaterial aus Glasvlies, Papier, einer Folie oder einem sonstigen Material besteht.

7. Außenfassade nach Anspruch 5 oder 6, **dadurch gekennzeichnet**, daß das Widerstandsmaterial Graphit, Ruß oder ein sonstiges Widerstandsmaterial ist.

8. Außenfassade nach einem der Ansprüche 5 bis 7, **dadurch** **gekennzeichnet**, daß die Dispersion mit dem Basismaterial durch Tränken, Bestreichen, Aufspachteln, Aufspritzen oder auf sonstige Weise in Verbindung gebracht ist.

9. Außenfassade nach einem der Ansprüche 1 bis 8, **dadurch gekennzeichnet**, daß die Widerstandsschicht (3) des Resonanzabsorbers an der Außenschale angebracht ist.

10. Außenfassade nach Anspruch 9, **dadurch gekennzeichnet**, daß die Außenschale (2) auf der der Innenschale (1) zugewandten Seite mit der Widerstandsschicht (3) beschichtet ist.

11. Außenfassade nach einem der Ansprüche 1 bis 10, **dadurch** **gekennzeichnet**, daß die Widerstandsschicht (3) des Resonanzabsorbers mehrere im wesentlichen parallel zu der Außenschale hintereinander angeordnete Einzelschichten, die eine unterschiedliche Permeabilität und/oder eine unterschiedliche Dielektrizitätszahl derart aufweisen oder unterschiedlich derart beabstandet sind, daß der Eingangswellenwiderstand an den Feldwellenwiderstand angepaßt ist, umfaßt.

12. Außenfassade nach einem der Ansprüche 1 bis 11, **dadurch gekennzeichnet**, daß die elektrisch leitende Schicht (4) des Resonanzabsorbers durch eine Wandung (4) aus Metallplatten gebildet ist.

13. Außenfassade nach einem der Ansprüche 1 bis 12, **dadurch gekennzeichnet**, daß die elektrisch leitende Schicht (4) des Resonanzabsorbers die Unterkonstruktion (7) für die Halterung der Außenschale umfaßt.

14. Außenfassade nach einem der Ansprüche 1 bis 13, **dadurch gekennzeichnet**, daß die elektrisch leitende Schicht (4) des Resonanzabsorbers Metallplatten aufweist.

15. Außenfassade nach einem der Ansprüche 1 bis 14, **dadurch gekennzeichnet**, daß zwischen der Außenschale und der Innenschale (1) eine Wärme- und/oder Lärmdämmschicht (5) angeordnet ist.

16. Außenfassade nach Anspruch 15, **dadurch gekennzeichnet**, daß die Dämmschicht (5) zwischen der Innenschale (1) und der zweiten Schicht (4) des Resonanzabsorbers angeordnet ist.

17. Außenfassade nach Anspruch 15 oder 16, **dadurch gekennzeichnet**, daß die Dämmschicht (5) bzw. die ein Dämmaterial aufweisenden Schichten (5′) aus einem unbrennbaren Material, vorzugsweise Mineralwolle, bestehen.

18. Außenfassade nach einem der Ansprüche 1 bis 17, **dadurch gekennzeichnet**, daß die elektrisch leitende Schicht (4) des Resonanzabsorbers durch die Innenschale (1) gebildet ist.

## Claims

1. Radar beam-absorbing outer façade with an outer shell (2) made of a material with low permeability and/or a low dielectric constant and with an inner shell (1), between which is arranged a layer of electromagnetically active resistance material (3), in relation to which, at a distance of λ/4 of a wavelength λ to be absorbed preferentially, is arranged an electrically conductive layer (4) for forming a resonance absorber, characterised in that between the layer (3) of electromagnetically active resistance material and the electrically conductive layer (4) is provided a radar beam-absorbing course which has a layered structure such that a layer comprising an insulating material (5′) and a layer comprising an electromagnetically active resistance material (3′) are arranged alternately succeeding each other in such a way that the butt faces of the different layers (3′, 5′) of insulating material and resistance material are arranged essentially perpendicularly to the outer shell.

2. Outer façade according to claim 1, characterised in that the outer shell (2, 2′) is made of glass, acrylic glass, cement-bound chipboard material, ceramic, mineral cement-bound board material or plastic.

3. Outer façade according to either of claims 1 or 2, characterised in that the inner shell (1, 1′) comprises a layer of electrically conductive material.

4. Outer facade according to claim 3, characterised in that the electrically conductive layer of the inner shell (1, 1′) encompasses the reinforcement of a reinforced concrete wall.

5. Outer facade according to any of claims 1 to 4, characterised in that the layer (3) of the resonance absorber comprising a resistance material or the layers (3′) of the radar beam-absorbing course comprising a resistance material consist of a base material which is brought into contact with a dispersion of resistance material.

6. Outer facade according to claim 5, characterised in that the base material consists of glass fibre mat, paper, a film or other material.

7. Outer facade according to claim 5 or 6, characterised in that the resistance material is graphite, soot or other resistance material.

8. Outer facade according to any of claims 5 to 7, characterised in that the dispersion is brought into contact with the base material by impregnation, brushing, spreading, spraying or otherwise.

9. Outer facade according to any of claims 1 to 8, characterised in that the resistance layer (3) of the resonance absorber is applied to the outer shell.

10. Outer facade according to claim 9, characterised in that the outer shell (2) is coated with the resistance layer (3) on the side facing towards the inner shell (1).

11. Outer facade according to any of claims 1 to 10, characterised in that the resistance layer (3) of the resonance absorber includes several individual layers which are arranged one behind the other essentially parallel to the outer shell and which have different permeability and/or a different dielectric constant or are differently spaced apart such that the input characteristic impedance is adapted to the field characteristic impedance.

12. Outer facade according to any of claims 1 to 11, characterised in that the electrically conductive layer (4) of the resonance absorber is formed by a wall (4) of metal plates.

13. Outer facade according to any of claims 1 to 12, characterised in that the electrically conductive layer (4) of the resonance absorber includes the substructure (7) for support of the outer shell.

14. Outer facade according to any of claims 1 to 13, characterised in that the electrically conductive layer (4) of the resonance absorber comprises metal plates.

15. Outer facade according to any of claims 1 to 14, characterised in that between the outer shell and the inner shell (1) is arranged a heat and/or sound-insulating layer (5).

16. Outer facade according to claim 15, characterised in that the insulating layer (5) is arranged between the inner shell (1) and the second layer (4) of the resonance absorber.

17. Outer facade according to claim 15 or 16, characterised in that the insulating layer (5) or the layers (5′) comprising an insulating material consist of a non-combustible material, preferably mineral wool.

18. Outer facade according to any of claims 1 to 17, characterised in that the electrically conductive layer (4) of the resonance absorber is formed by an inner shell (1).

## Revendications

1. Façade extérieure absorbant des faisceaux radars comprenant une coque extérieure (2) en un matériau présentant une faible perméabilité et/ou une faible constante diélectrique et une coque intérieure (1), entre lesquelles est disposée une couche qui est constituée d'un matériau résistif (3) électromagnétiquement actif et par rapport à laquelle est disposée une couche (4) électriquement conductrice à une distance de λ/4 d'une longueur d'onde λ à absorber de préférence, en vue de former un absorbeur par résonance, **caractérisée** par le fait qu'il est prévu entre la couche (3) constituée du matériau résistif électromagnétiquement actif et la couche (4) électriquement conductrice, une couche qui absorbe des faisceaux radars et qui présente une structure de couche de telle sorte qu'une couche (5′) comportant un matériau isolant et une couche (3′) comportant un matériau résistif électromagnétiquement actif sont disposées alternativement et successivement de sorte que les surfaces de joint des différentes couches (3′, 5′) en matériau isolant et en matériau résistif sont disposés sensiblement perpendiculairement à la coque extérieure.

2. Façade extérieure selon la revendication 1, **caractérisée** par le fait que la coque extérieure (2, 2′) est constituée de verre, de verre acrylique, de matériau de panneau de particules de bois lié dans du ciment, de céramique, de matériau minéral en plaque lié dans du ciment ou de matière plastique.

3. Façade extérieure selon l'une des revendications 1 ou 2, **caractérisée** par le fait que la coque intérieure (1, 1′) comporte une couche en un matériau électriquement conducteur.

4. Façade extérieure selon la revendication 3, **caractérisée** par le fait que la couche électriquement conductrice de la coque intérieure (1, 1′) comprend l'armature d'une paroi en béton armé.

5. Façade extérieure selon l'une des revendications 1 à 4, **caractérisée** par le fait que la couche (3) comportant un matériau résistif, de l'absorbeur par résonance, respectivement les couches (3′) comportant un matériau resistif, de la couche absorbant des faisceaux radars sont constituées d'un matériau de base qui est lié avec une dispersion en un matériau résistif.

6. Façade extérieure selon la revendication 5, **caractérisée** par le fait que le matériau de base est constitué d'un mat de fibres de verre, de papier, d'une feuille ou d'un autre matériau.

7. Façade extérieure selon la revendication 5 ou 6, **caractérisée** par le fait que le matériau résistif est du graphite, de la suie ou un autre matériau résistif.

8. Façade extérieure selon l'une des revendications 5 à 7, **caractérisée** par le fait que la dispersion est liée au matériau de base par imprégnation, enduction, application à la spatule, pulvérisation ou d'une autre manière.

9. Façade extérieure selon l'une des revendications 1 à 8, **caractérisée** par le fait que la couche résistive (3) de l'absorbeur par résonance est appliquée sur la coque extérieure.

10. Façade extérieure selon la revendication 9, **caractérisée** par le fait que la coque extérieure (2) est recouverte avec la couche résistive (3), sur le côté tourné vers la coque intérieure (1).

11. Façade extérieure selon l'une des revendications 1 à 10, **caractérisée** par le fait que la couche résistive (3) de l'absorbeur par résonance comprend plusieurs couches individuelles qui sont disposées les unes derrière les autres, sensiblement parallèlement à la coque extérieure et présentent une perméabilité différente et/ou une constante diélectrique différente ou sont espacées différemment de sorte que l'impédance caractéristique d'entrée est adaptée à l'impédance de champ caractéristique.

12. Façade extérieure selon l'une des revendications 1 à 11, **caractérisée** par le fait que la couche (4) électriquement conductrice de l'absorbeur par résonance est formée par une paroi (4) de plaques métalliques.

13. Façade extérieure selon l'une des revendications 1 à 12, **caractérisée** par le fait que la couche (4) électriquement conductrice de l'absorbeur par résonance comprend la construction de support (7) pour la fixation de la coque extérieure.

14. Façade extérieure selon l'une des revendications 1 à 13, **caractérisée** par le fait que la couche (4) électriquement conductrice de l'absorbeur par résonance comporte des plaques métalliques.

15. Façade extérieure selon l'une des revendications 1 à 14, **caractérisée** par le fait qu'une couche isolante calorifuge et/ou insonorisante (5) est disposée entre la coque extérieure et la coque intérieure (1).

16. Façade extérieure selon la revendication 15, **caractérisée** par le fait que la couche isolante (5) est disposée entre la coque intérieure (1) et la deuxième couche (4) de l'absorbeur par résonance.

17. Façade extérieure selon la revendication 15 ou 16, **caractérisée** par le fait que la couche isolante (5), respectivement les couches (5′) comportant un matériau isolant sont constituées d'un matériau non inflammable de préférence de laine minérale.

18. Façade extérieure selon l'une des revendications 1 à 17, **caractérisée** par le fait que la couche (4) électriquement conductrice de l'absorbeur par résonance est formée par la coque intérieure (1).
